# EUROPEAN PATENT SPECIFICATION

(11) **EP 2 169 759 B1**
(45) Date of publication and mention of the grant of the patent: **17.10.2012**
(21) Application number: 08791075.8
(22) Date of filing: 11.07.2008
(51) Int. Cl.: H01M 14/00, H01L 31/04, H01G 9/20

(54) **PHOTOELECTRIC CONVERSION ELEMENT AND METHOD FOR MANUFACTURING THE SAME**
PHOTOELEKTRISCHE UMWANDLUNGSVORRICHTUNG UND VERFAHREN ZU DEREN HERSTELLUNG
ELÉMENT DE CONVERSION PHOTOÉLECTRIQUE ET SON PROCÉDÉ DE FABRICATION

(30) Priority: 12.07.2007 JP 2007183329
(43) Date of publication of application: 31.03.2010
(73) Proprietor: Hitachi Zosen Corporation, Osaka-shi, Osaka 559-8559 (JP)
(72) Inventor: INOUE, Tetsuya, Osaka-shi Osaka 559-8559 (JP); SUGIYO, Takeshi, Osaka-shi Osaka 559-8559 (JP)
(74) Representative: Paul, Dieter-Alfred
(86) International application number: PCT/JP2008/062545
(87) International publication number: WO 2009/008494

(56) References cited:
- EP-A1- 1 691 442
- WO-A1-2004/100196
- WO-A1-2006/067969
- JP-A- 2002 335 004
- JP-A- 2004 111 216
- JP-A- 2004 165 474
- JP-A- 2004 241 228
- JP-A- 2004 319 661
- KAZUHARU SUZUKI ET AL.: 'Application of Carbon Nanotubes to Counter Electrodes of Dye-sensitized Solar Cells' CHEMISTRY LETTERS vol. 32, no. 1, 05 January 2003, pages 28 - 29, XP008025168
- WON JAE LEE ET AL.: 'Dye-sensitized solar cells with spray-coated CNT counter electrode' PROCEEDINGS OF SPIE PHOTONICS: DESIGN, TECHNOLOGY, AND PACKAGING II, THE INTERNATIONAL SOCIETY FOR OPTICAL ENGINEERING vol. 6038, 12 December 2005, pages 60381T1 - 60381T8, XP008127092

## Description

The present invention relates to a photoelectric conversion element such as a solar battery and further to a method of producing the same.

Generally, a photoelectric conversion element such as a dye-sensitized type solar battery is made of a reference electrode constructed by forming a transparent conductive film on a transparent substrate such as a glass plate and dyeing the conductive film with a photosensitizing dye, a counter electrode constructed by forming a transparent conductive film on a substrate for the counter electrode, and an electrolyte solution allowed to intervene between the two electrodes.

Further, a photoelectric conversion element is proposed that improves the electric power generation efficiency by disposing a brush-shaped carbon nanotube oriented substantially perpendicularly to the substrate thereof on the transparent conductive film of the counter electrode in order to improve the movement of electrons from the counter electrode to the electrolyte solution (See Patent Document 1).
Patent Document 1: Japanese Unexamined Patent Publication (JP-A) No. 2006-202721, also published as WO/2006/067969.

However, with the photoelectric conversion element having the above construction, although an improvement in the power generation efficiency can be expected by providing a brush-shaped carbon nanotube in the counter electrode, there arises a problem in that the transparent conductive film of the counter electrode is corroded because a corrosive substance such as iodine is contained in the electrolyte solution.

Moreover, in order to orient the brush-shaped carbon nanotube to the transparent conductive film on the substrate of the counter electrode, the chemical vapor deposition method must be used, whereby the substrate and the transparent conductive film are exposed to high temperature, thereby raising a problem in that the materials thereof are limited to those having a heat resistance.

Therefore, an object of the present invention is to provide a photoelectric conversion element having a high power generation efficiency, raising no problem of corrosion, and being applicable to a substrate having a low heat resistance, as well as a method of producing the same.

The present invention provides a photoelectric conversion element formed in such a manner that a reference electrode serving as a negative electrode and a counter electrode serving as a positive electrode are arranged to oppose each other, wherein
the reference electrode is constructed by forming a photocatalyst film dyed with a photosensitizing dye via a transparent conductive film on one surface of a transparent substrate, and
the counter electrode is constructed by disposing, on one surface of a substrate for the counter electrode, a brush-shaped carbon nanotube oriented substantially perpendicularly to the substrate surface by transcribing a separately formed brush-shaped carbon nanotube via a conductive adhesive agent layer that covers the surface.

In the photoelectric conversion element according to the present invention, the reference electrode is preferably constructed by allowing a brush-shaped carbon nanotube disposed substantially perpendicularly to the substrate surface on the transparent conductive film on the transparent substrate to carry photocatalyst particles, and dyeing the particles with a photosensitizing dye.

The reference electrode is preferably constructed by forming a photocatalyst film made of a mixture of carbon nanotube particles and photocatalyst particles on the transparent conductive film on the transparent substrate, and dyeing the catalyst film with a photosensitizing dye.

The reference electrode may be in contact with the brush-shaped carbon nanotube of the counter electrode.

The present invention provides a method of producing a photoelectric conversion element formed in such a manner that a reference electrode serving as a negative electrode and a counter electrode serving as a positive electrode are arranged to oppose each other, wherein
the reference electrode is constructed by forming a photocatalyst film dyed with a photosensitizing dye via a transparent conductive film on one surface of a transparent substrate, and
the counter electrode is constructed by forming, on one surface of a substrate for the counter electrode, a conductive adhesive agent layer to cover the surface, and transcribing a separately formed brush-shaped carbon nanotube onto the adhesive agent layer in such a manner that the brush-shaped carbon nanotube may be oriented substantially perpendicularly to the substrate surface.

In the method of producing a photoelectric conversion element according to the present invention, the reference electrode is constructed by forming a transparent conductive film on one surface of a transparent substrate, transcribing a separately formed brush-shaped carbon nanotube onto the conductive film in such a manner that the brush-shaped carbon nanotube may be oriented substantially perpendicularly to the substrate surface, allowing the carbon nanotube to carry photocatalyst particles, and dyeing the particles with a photosensitizing dye.

The reference electrode is preferably constructed by forming a transparent conductive film on one surface of a transparent substrate, forming a photocatalyst film made of a mixture of carbon nanotube particles and photocatalyst particles on the conductive film, and dyeing the catalyst film with a photosensitizing dye.

In forming a photocatalyst film made of a mixture of carbon nanotube particles and photocatalyst particles on the transparent conductive film, a paste containing the mixture is preferably applied onto the transparent conductive film, followed by drying. In this case, in applying the paste onto the transparent conductive film, the application is preferably carried out in a state in which an electrostatic field is formed between the transparent conductive film and the electrode opposing thereto.

In the present invention, the transparent substrate of the reference electrode may be a glass plate, a plastic plate, or the like. The transparent conductive film of the reference electrode is preferably a thin film containing, for example, a conductive metal oxide such as tin-added indium oxide [Indium Tin Oxide (TIN)], fluorine-added tin oxide [Fluorine doped Tin Oxide (FTO)], or tin oxide [SnO₂].

The photosensitizing dye may be, for example, a ruthenium complex or an iron complex having a ligand containing a bipyridine structure, a terpyridine structure, or the like, a metal complex of porphyrin series or phthalocyanine series, or further an organic dye such as eosine, rhodamine, merocyanine, or coumalin.

The photocatalyst may be a metal oxide such as titanium oxide (TiO₂), tin oxide (SnO₂), tungsten oxide (WO₃), zinc oxide (ZnO), or niobium oxide (Nb₂O₅).

The substrate for the counter electrode is made of a metal sheet such as aluminum, copper, or tin.

The conductive adhesive agent layer of the counter electrode may be made of a carbon-series conductive adhesive agent, but is not limited thereto.

In accordance with the needs, an electrolyte solution may be allowed to intervene between the reference electrode serving as the negative electrode and the counter electrode serving as the positive electrode. The electrolyte solution may be one in which an electrolyte component such as iodine, iodide ion, or tertiary-butylpyridine is dissolved in an organic solvent such as ethylene carbonate or methoxyacetonitrile.

The formation and the transcription of the brush-shaped carbon nanotube is carried out in accordance with known methods.

According to the present invention, because one surface of the substrate for the counter electrode is covered with a conductive adhesive agent layer, even in a case in which an electrolyte solution containing a corrosive substance is allowed to intervene between the two electrodes, the electrolyte solution is not brought into contact with the substrate. Therefore, the counter electrode substrate will not be corroded by the electrolyte solution. This can construct a solar battery cell having a high electric power conversion efficiency and being provided with a counter electrode excellent in corrosion resistance.

Also, by transcribing a separately formed brush-shaped carbon nanotube on one surface of the substrate for the counter electrode via the conductive adhesive agent layer, a substrate having a low heat resistance can be applied and used as the substrate for the counter electrode.

In addition, when the counter electrode is made of a sheet-shaped electrode and the sheet of the reference electrode is formed to be provided with a photocatalyst film, a flexible photoelectric conversion element can be provided.

According to the present invention, movement of electrons will be improved by the brush-shaped carbon nanotube of the counter electrode and the carbon nanotube contained in the photocatalyst, so that a highly efficient dye-sensitized type solar battery cell can be constructed even with a smaller amount of electrolyte solution as compared with that of a conventional one.

Next, in order to describe the present invention specifically, some Examples of the present invention will be given.

### EXAMPLE 1

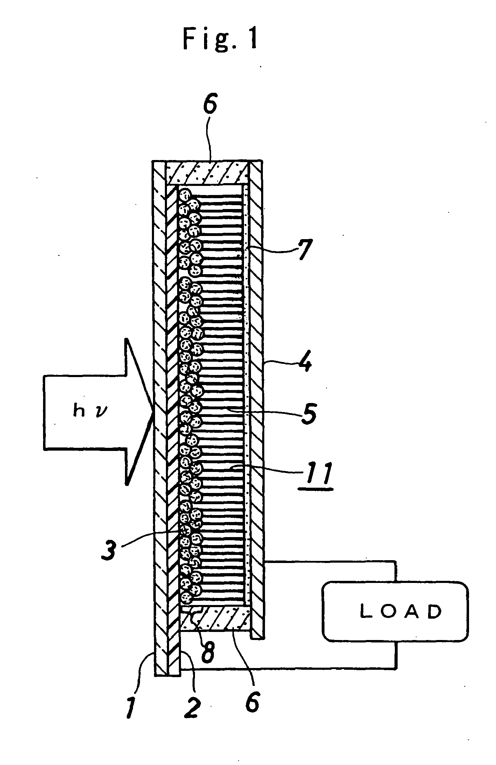

In Fig. 1, a transparent conductive film (2) was formed on one surface of a transparent substrate (1) for a photocatalyst electrode (a reference electrode) made of glass or plastics. A photocatalyst film (8) made of titanium oxide particles (3) was formed to a thickness of 10 to 15 µm on the conductive film (2). The photocatalyst film (8) was formed by applying a paste containing titanium oxide particles having an average particle size of 20 to 30 nm onto the transparent substrate (1), followed by sintering.

After the photocatalyst film (8) was dyed with a ruthenium series dye referred to as "N3" or "N719", the photocatalyst film (8) was impregnated with an iodine series electrolyte solution. In this manner, a photocatalyst electrode (a reference electrode) was constructed.

On the other hand, a carbon series conductive adhesive agent was applied onto the whole surface of one surface of a counter electrode substrate (4) made of a metal sheet. On an adhesive layer (7), a carbon nanotube formed substantially perpendicularly to a base material separately by a method such as the thermochemical vapor deposition method or the plasma chemical vapor deposition method was transcribed from the base material to the counter electrode substrate (4) via the conductive adhesive agent layer (7) so that the carbon nanotube would be oriented substantially perpendicularly, thereby to form a counter electrode (positive electrode) (11). An iodine series electrolyte solution was applied onto the surface (counter electrode surface) of a carbon nanotube film (5). The carbon nanotube film (5) of the counter electrode had a thickness of 20 µm.

The photocatalyst electrode (negative electrode) was disposed to be parallel to the counter electrode (positive electrode) so that the photocatalyst film (8) of the former would face the carbon nanotube film (5) of the latter. A sealing piece (6) made of thermosetting resin or photosetting resin was allowed to intervene between the peripheries of the two electrodes, and the two electrodes were integrated with the sealing piece (6), thereby to construct a dye-sensitized solar battery cell.

On this cell construction, the electric power conversion efficiency was measured by standard light source radiation of AM 1.5 and 100 mW/cm², with a result that the conversion efficiency was 5.6%.

With a solar battery cell constructed by using a conventional paste containing a carbon nanotube, the electric power conversion efficiency is about 2 to 3%, so that an electric power conversion efficiency of a high value of about the double has been obtained. This is because a circuit formation having a low electric resistance has been made by a substantially perpendicular carbon nanotube.

In addition, the corrosiveness by the iodine series electrolyte solution applied onto the surface of the counter electrode was examined. As a result thereof, it was confirmed that the counter electrode surface did not change from the initial state, and is excellent in durability.

### EXAMPLE 2

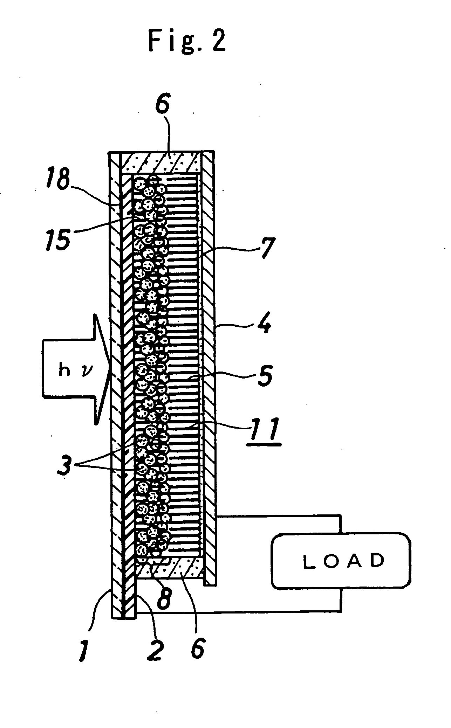

In Fig. 2, to a transparent substrate (1) made of glass or plastics whose surface is covered with a transparent conductive film (18) such as ITO, a transparent conductive film (2) of conductive polymer such as PEDOT or PEDOT/PSS was formed on this transparent conductive film. Separately, a carbon nanotube formed substantially perpendicularly to a base material by a method such as the thermochemical vapor deposition method or the plasma chemical vapor deposition method was transcribed from the base material to the transparent conductive film (2) so that the carbon nanotube would be oriented substantially perpendicularly. The carbon nanotube film (15) had a thickness of about 8 µm.

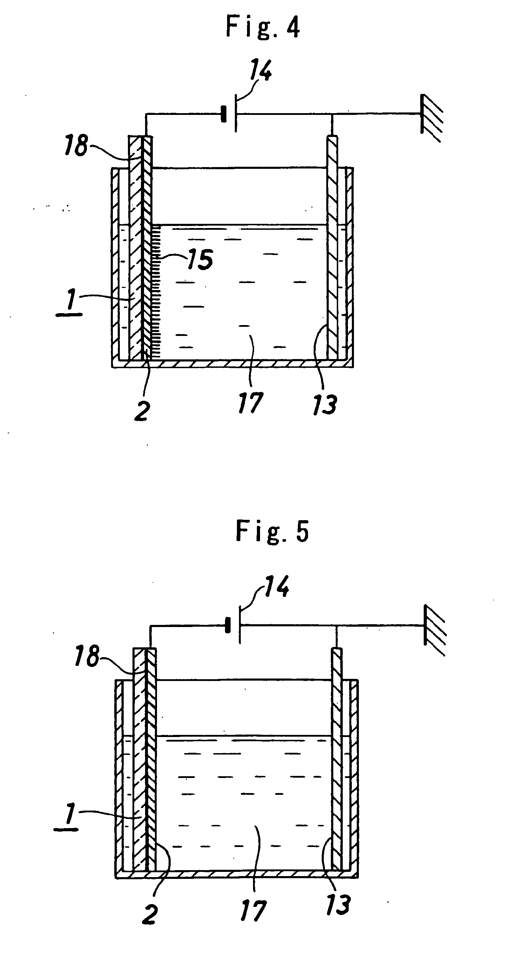

Next, as shown in Fig. 4, the substrate (1) with this carbon nanotube film (15) was immersed into a dispersion liquid (preferably an alcohol dispersion liquid) (17) in which titanium oxide particles (having an average particle size of 20 nm) were dispersed. An electric field of about -1 kV/cm was formed by a high-voltage power source (14) between an electrode (13) disposed in the liquid (17) to oppose to the substrate (1) and the conductive film (2) of the substrate (1), whereby the titanium oxide particles (3) were moved into the carbon nanotube film (15) by the electrophoresis method so as to be carried. Here, the two are connected so that the conductive film (2) side of the substrate (1) will be a negative high voltage, and the electrode (13) side will be grounded.

After a photocatalyst film (8) made of the carbon nanotube film (15) and the titanium oxide particles (3) carried thereon was dyed with a ruthenium series dye referred to as "N3" or "N719", an iodine series electrolyte solution was applied onto the surface of the photocatalyst film (8). In this manner, a photocatalyst electrode was constructed.

Instead of the electrophoresis method, after a solution of chloride or hydroxide which will be a precursor of a photocatalyst is applied onto the substrate (1) with the carbon nanotube film, the carbon nanotube film surface can be allowed to carry predetermined photocatalyst particles by oxidizing the precursor with use of water vapor or the like. Alternatively, the carbon nanotube surface can be allowed to carry photocatalyst particles by dropping, drying, and sintering a dilution liquid obtained by diluting a paste containing a photocatalyst such as titanium oxide particles having an average particle size of 20 to 30 nm with alcohol or the like.

The photocatalyst film (8) made of the carbon nanotube film (15) and the titanium oxide particles (3) carried thereon carries the catalyst up to each tube tip end (the surface of the carbon nanotube film).

A counter electrode (positive electrode) (11) was formed in the same manner as in Example 1.

The thickness of the carbon nanotube film (5) of the counter electrode is 20 µm.

The photocatalyst electrode (negative electrode) was disposed to be parallel to the counter electrode (positive electrode) so that the photocatalyst film (8) of the former would face the carbon nanotube film (5) of the latter. A sealing piece (6) made of thermosetting resin or photosetting resin was allowed to intervene between the peripheries of the two electrodes, and the two electrodes were integrated with the sealing piece (6), thereby to construct a dye-sensitized solar battery cell.

On this cell construction, the electric power conversion efficiency was measured by standard light source radiation of AM 1.5 and 100 mW/cm², with a result that the electric power conversion efficiency was 7.0%. Also, when a method was carried out in which, instead of the electrophoresis method, after a precursor solution of a photocatalyst was applied onto the substrate (1) with the carbon nanotube film, the carbon nanotube film surface was allowed to carry predetermined photocatalyst particles by passing through the precursor oxidization, or when the photocatalyst particles were allowed to be carried by the dilution/dropping method, the electric power conversion efficiency was 6.6 to 6.8%.

The conversion efficiency can be further improved by optimizing the density of the carbon nanotube film, the amount of titanium oxide carried thereon, and the like.

### EXAMPLE 3

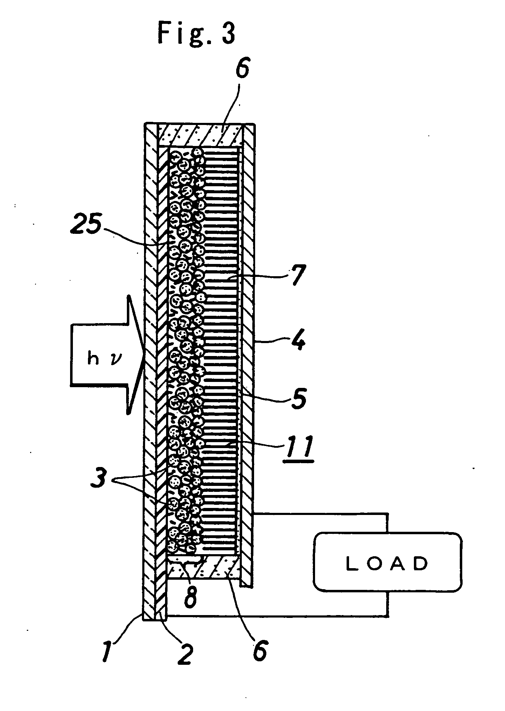

In Fig. 3, a transparent conductive film (2) was formed on one surface of a transparent substrate (1) for a photocatalyst electrode (a reference electrode) made of glass or plastics.

Separately, a paste was prepared by mixing titanium oxide photocatalyst particles (having an average particle size of 20 nm) and particles of carbon nanotube (multi-wall nanotube (MWNT)) having a length of 1 µm (those obtained by dispersing MWNT into alcohol, finely grinding with use of a supersonic cleaner, and taking out MWNT of 1 µm or less with use of a filter), and adding alcohol and water to this mixture. In this Example, MWNT was used as the carbon nanotube; however, a single wall nanotube (SWNT) or a double wall nanotube (DWNT) may be used as well.

This paste was applied onto the transparent conductive film (2) on the transparent substrate (1) with use of a doctor blade to form a film, which was then dried at a temperature of 150°C, so as to form a photocatalyst film (8) containing titanium oxide particles (3) and carbon nanotube particles (25).

In this Example, the film was formed by using a paste containing titanium oxide particles (3) and carbon nanotube particles (25). Alternatively, the film can be formed by the electrophoresis method by diluting the above paste liquid, immersing the substrate (1) with the transparent conductive film (2) into this dilution liquid, and forming an electric field of about -1 kV/cm on the substrate side. In other words, in Fig. 5, to a transparent substrate (1) made of glass or plastics whose surface is covered with a transparent conductive film (18) such as ITO, a transparent conductive film (2) of conductive polymer such as PEDOT or PEDOT/PSS was formed on this transparent conductive film. This transparent substrate (1) was immersed into a dispersion liquid (preferably an alcohol dispersion liquid) (17) in which titanium oxide particles (3) and carbon nanotube particles (25) were dispersed. An electric field of about -1 kV/cm was formed by a high-voltage power source (14) between an electrode (13) disposed in the liquid (17) to oppose to the substrate (1) and the conductive film (2) of the substrate (1), thereby to form a photocatalyst film (8) containing the titanium oxide particles (3) and the carbon nanotube particles (25) by the electrophoresis method. Here, the two are connected so that the conductive film (2) side of the substrate (1) will be a negative high voltage, and the electrode (13) side will be grounded.

After the photocatalyst film (8) was dyed with a ruthenium series dye referred to as "N3" or "N719", an iodine series electrolyte solution was applied onto the surface of the photocatalyst film (8). In this manner, a photocatalyst electrode was constructed.

A counter electrode (positive electrode) (11) was formed in the same manner as in Example 1.

The photocatalyst electrode (negative electrode) was disposed to be parallel to the counter electrode (positive electrode) so that the photocatalyst film (8) of the former would face the carbon nanotube film (5) of the latter. A sealing piece (6) made of thermosetting resin or photosetting resin was allowed to intervene between the peripheries of the two electrodes, and the two electrodes were integrated with the sealing piece (6), thereby to construct a dye-sensitized solar battery cell.

On the cell construction, the electric power conversion efficiency was measured by standard light source radiation of AM 1.5 and 100 mW/cm², with a result that the conversion efficiency was 6.6%. Also, when the photocatalyst electrode was fabricated by the electrophoresis method, the electric power conversion efficiency was measured by standard light source radiation of AM 1.5 and 100 mW/cm² on the constructed dye-sensitized solar battery cell, with a result that the conversion efficiency was 6.5 to 6.8%.

### EXAMPLE 4

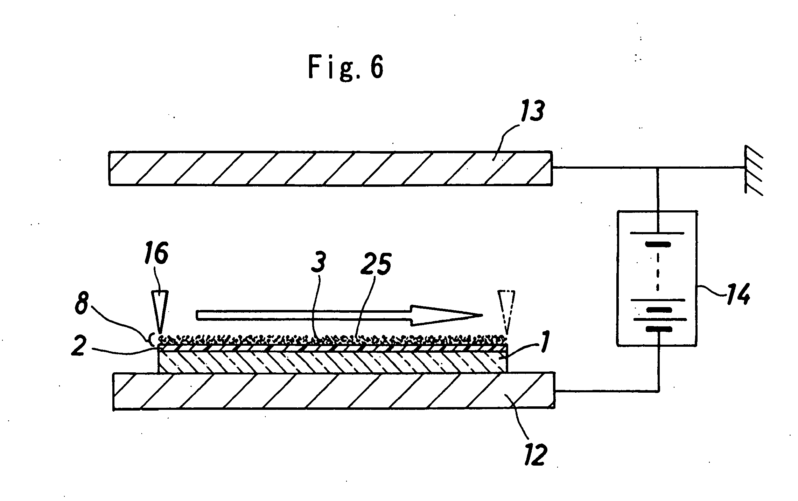

In Fig. 6, a transparent substrate (1) for a photocatalyst electrode (a reference electrode) made of glass substrate or plastics whose surface is covered with a transparent conductive film (2) such as ITO was disposed on an electrode (12) made of metal plate to which a high-voltage power source (14) was connected. A counter electrode (13) made of metal plate was disposed to face this substrate (1). A negative high voltage was applied between these electrodes (12)(13) to form an electrostatic field. Here, the two are connected so that the electrode (12) side will be a negative high voltage, and the counter electrode (13) side will be grounded.

In this Example, an electric field of -1.5 to -2 kV/cm was formed between the electrodes.

In this state, a paste containing a mixture of a photocatalyst such as titanium oxide particles (3) and carbon nanotube particles (25) finely ground by a supersonic cleaner was applied onto the transparent electrode film. Further, the paste was extended with use of a doctor blade (16) formed by a spatula made of resin so that the paste surface would be uniform, thereby to form a coating film.

The carbon nanotube particles contained in a dispersion form in this coating film will move to the substrate (1) side by the electrostatic field formed between the electrodes, or will be aligned in a perpendicular direction to the substrate (1) surface in the photocatalyst layer. Here, no problem is raised even if the dispersed carbon nanotube particles are tilted slightly in an oblique direction without being oriented completely in the perpendicular direction to the substrate (1) surface.

In this state, the wet coating film was dried by warm wind or hot wind from the outside, and was sintered to form a photocatalyst film (8) containing titanium oxide particles (3) and carbon nanotube particles (25) on the transparent conductive film (2) on the substrate (1).

After the photocatalyst film (8) was dyed with a ruthenium series dye referred to as "N3" or "N719", an iodine series electrolyte solution was applied onto the surface of the photocatalyst film (8). In this manner, a photocatalyst electrode was constructed.

In this Example, the film thickness at the time of paste application was about 100 µm, and the film thickness of the photocatalyst layer (8) after drying and sintering was about 10 µm.

A counter electrode (positive electrode) (11) was formed in the same manner as in Example 1.

A dye-sensitized solar battery cell was constructed in the same manner as in Example 1 from the photocatalyst electrode (negative electrode) and the counter electrode (positive electrode).

On this cell construction, the electric power conversion efficiency was measured by standard light source radiation of AM 1.5 and 100 mW/cm², with a result that the conversion efficiency was 6.5 to 6.8%.

[FIG. 1] Fig. 1 is a cross-sectional view illustrating a solar battery cell according to Example 1.
[FIG. 2] Fig. 2 is a cross-sectional view illustrating a solar battery cell according to Example 2.
[FIG. 3] Fig. 3 is a cross-sectional view illustrating a solar battery cell according to Example 3.
[FIG. 4] Fig. 4 is a cross-sectional view illustrating the electrophoresis method in Example 2.
[FIG. 5] Fig. 5 is a cross-sectional view illustrating a method of forming a photocatalyst layer by the electrophoresis method in Example 3.
[FIG. 6] Fig. 6 is a cross-sectional view illustrating a method of forming a photocatalyst layer by the electrostatic method in Example 4.

- (1): transparent substrate
- (2) (18): transparent conductive film
- (3): titanium oxide particles
- (4): substrate for counter electrode
- (5) (15): carbon nanotube film
- (6): sealing piece
- (7): conductive adhesive agent layer
- (8): photocatalyst film
- (11): counter electrode
- (12)(13): electrode
- (14): high-voltage power source
- (16): doctor blade
- (17): dispersion liquid
- (25): carbon nanotube particles

## Claims

1. A photoelectric conversion element formed in such a manner that a reference electrode serving as a negative electrode and a counter electrode (11) serving as a positive electrode are arranged to oppose each other, wherein
the reference electrode is constructed by forming a photocatalyst film (8) dyed with a photosensitizing dye via a transparent conductive film (2, 18) on one surface of a transparent substrate (1) and
the counter electrode (11) is constructed by disposing, on one surface of a substrate for the counter electrode (4), a brush-shaped carbon nanotube oriented substantially perpendicularly to the substrate surface by transcribing a separately formed brush-shaped carbon nanotube via a conductive adhesive agent layer (7) that covers the surface.

2. The photoelectric conversion element according to claim 1, wherein the reference electrode is constructed by allowing a brush-shaped carbon nanotube disposed substantially perpendicularly to the substrate surface on the transparent conductive film (2, 18) on the transparent substrate (1) to carry photocatalyst particles, and dyeing the particles with a photosensitizing dye.

3. The photoelectric conversion element according to claim 1, wherein the reference electrode is constructed by forming a photcatalyst film (8) made of a mixture of carbon nanotube particles (25) and photocatalyst particles on the transparent conductive film (2, 18) on the transparent substrate (1), and dyeing the catalyst film (8) with a photosensitizing dye.

4. The photoelectric conversion element according to claim 3, wherein the reference electrode is in contact with the brush-shaped carbon nanotube of the counter electrode (11).

5. A method of producing a photoelectric conversion element formed in such a manner that a reference electrode serving as a negative electrode and a counter electrode (11) serving as a positive electrode are arranged to oppose each other, wherein
the reference electrode is constructed by forming a photocatalyst film (8) dyed with a photosensitizing dye via a transparent conductive film (2, 18) on one surface of a transparent substrate (1), and
the counter electrode (11) is constructed by forming, on one surface of a substrate for the counter electrode (4), a conductive adhesive agent layer (7) to cover the surface, and transcribing a separately formed brush-shaped carbon nanotube onto the adhesive agent layer (7) in such a manner that the brush-shaped carbon nanotube may be oriented substantially perpendicularly to the substrate surface.

6. The method of producing a photoelectric conversion element according to claim 5, wherein the reference electrode is constructed by forming a transparent conductive film (2, 18) on one surface of a transparent substrate (1), transcribing a separately formed brush-shaped carbon nanotube onto the conductive film in such a manner that the brush-shaped carbon nanotube may be oriented substantially perpendicularly to the substrate surface, allowing the carbon nanotube to carry photocatalyst particles, and dyeing the particles with a photosensitizing dye.

7. The method of producing a photoelectric conversion element according to claim 5, wherein the reference electrode is constructed by forming a transparent conductive film (2, 18) on one surface of a transparent substrate (1), forming a photocatalyst film (8) made of a mixture of carbon nanotube particles (25) and photocatalyst particles on the conductive film, and dying the catalyst film with a photosensitizing dye.

8. The method of producing a photoelectric conversion element according to claim 7, wherein, in forming a photocatalyst film (8) made of a mixture of carbon nanotube particles (25) and photocatalyst particles on the transparent conductive film (2, 18), a paste containing the mixture is applied onto the transparent conductive film (2, 18), followed by drying.

9. The method of producing a photoelectric conversion element according to claim 8, wherein, in applying the paste onto the transparent conductive film (2, 18), the application is carried out in a state in which an electrostatic field is formed between the transparent conductive film (2, 18) and the electrode opposing thereto.

## Patentansprüche

1. Fotoelektrisches Umwandlungselement, das derart ausgebildet ist, dass eine als negative Elektrode dienende Referenzelektrode und eine als positive Elektrode dienende Gegenelektrode (11) einander gegenüberliegend angeordnet sind, wobei
die Referenzelektrode hergestellt ist durch Ausbildung eines mit einem fotosensitiven Farbstoff gefärbten Fotokatalysator-Films (8) auf einem transparenten leitenden Film (2, 18) auf einer Oberfläche eines transparenten Substrats (1), und
die Gegenelektrode (11) hergestellt ist, indem auf einer Oberfläche eines Substrats für die Gegenelektrode (4) eine bürstenförmige Kohlenstoffnanoröhre, die im Wesentlichen senkrecht zu der Oberfläche des Substrats ausgerichtet ist, angeordnet ist, wobei eine gesondert hergestellte bürstenförmige Kohlenstoffnanoröhre mittels einer die Oberfläche bedeckenden leitenden Haftmittelschicht (7) befestigt wird.

2. Fotoelektrisches Umwandlungselement nach Anspruch 1, **dadurch gekennzeichnet, dass** die Referenzelektrode hergestellt ist, indem es einer im Wesentlichen senkrecht zu der Oberfläche des Substrats auf dem transparenten leitenden Film (2, 18) auf dem transparenten Substrat (1) angeordneten bürstenförmigen Kohlenstoffnanoröhre ermöglicht ist, Fotokatalysatorteilchen zu tragen, die mittels eines fotosensitiven Farbstoffs färbbar sind.

3. Fotoelektrisches Umwandlungselement nach Anspruch 1, **dadurch gekennzeichnet, dass** die Referenzelektrode hergestellt ist, indem ein Fotokatalysatorfilm (8), der aus einer Mischung von Kohlenstoffnanoröhrenteilchen (25) und Fotokatalysatorteilchen besteht, auf dem transparenten leitenden Film (2, 18) auf dem transparenten Substrat (1) ausgebildet und der Fotokatalysator-films (8) mit einem fotosensitiven Farbstoff gefärbt wird.

4. Fotoelektrisches Umwandlungselement nach Anspruch 3, **dadurch gekennzeichnet, dass** die Referenzelektrode mit der bürstenförmigen Kohlenstoffnanoröhre der Gegenelektrode (11) in Kontakt ist.

5. Verfahren zur Herstellung eines fotoelektrischen Umwandlungselements, welches hergestellt wird, indem eine Referenzelektrode, die als negative Elektrode dient und eine Gegenelektrode (11), die als positive Elektrode dient, einander gegenüberliegend angeordnet werden, wobei
die Referenzelektrode hergestellt wird, indem ein mit einem fotosensitiven Farbstoff gefärbter Fotokatalysator-Film (8) über einem transparenten leitenden Film (2, 18) auf einer Oberfläche eines transparenten Substrats (1) ausgebildet wird, und
die Gegenelektrode (11) hergestellt wird, indem auf einer Oberfläche eines Substrats für die Gegenelektrode (4) eine leitende Haftmittelschicht (7), ausgebildet wird, welche die Oberfläche bedeckt, und eine gesondert hergestellte bürstenförmige Kohlenstoffnanoröhre auf die leitende Haftmittelschicht (7) derart übertragen wird, dass die bürstenförmige Kohlenstoffnanoröhre im Wesentlichen senkrecht zu der Oberfläche des Substrats ausgerichtet ist.

6. Verfahren zur Herstellung eines elektrischen Umwandlungselements nach Anspruch 5, **dadurch gekennzeichnet, dass** die Referenzelektrode hergestellt wird, indem ein transparenter leitender Film (2, 18) auf einer Oberfläche eines transparenten Substrats (1) ausgebildet wird, und eine gesondert hergestellte bürstenförmige Kohlenstoffnanoröhre derart auf den leitenden Film übertragen wird, dass die bürstenförmige Kohlenstoffnanoröhre im Wesentlichen senkrecht zu der Oberfläche des Substrats ausgerichtet ist, wobei es ermöglicht wird, dass die Kohlenstoffnanoröhre Fotokatalysatorteilchen trägt und die Teilchen mit einem fotosensitiven Farbstoff gefärbt werden.

7. Verfahren zur Herstellung eines fotoelektrischen Umwandlungselements nach Anspruch 5, **dadurch gekennzeichnet, dass** die Referenzelektrode hergestellt wird, indem ein transparenter leitender Film (2, 18) auf einer Oberfläche eines transparenten Substrats (1) ausgebildet wird, und ein Fotokatalysatorfilm, welcher aus einer Mischung von Kohlenstoffnanoröhrenteilchen (25) und Fotokatalysatorteilchen hergestellt ist, auf dem leitenden Film ausgebildet wird, wobei der Katalysatorfilm mit einem fotosensitiven Farbstoff gefärbt wird.

8. Verfahren zur Herstellung eines fotoelektrischen Umwandlungselements nach Anspruchs 7, **dadurch gekennzeichnet, dass** der Fotokatalysatorfilm (8), welcher aus einer Mischung aus Kohlenstoffnanoteilchen (25) und Fotokatalysatorteilchen besteht, auf dem transparenten leitenden Film (2, 18) ausgebildet wird, indem eine die Mischung enthaltende Paste auf den transparenten leitenden Film (2, 18) aufgetragen und anschließend getrocknet wird.

9. Verfahren zur Herstellung eines fotoelektrischen Umwandlungselements nach Anspruch 8, **dadurch gekennzeichnet, dass** das Auftragen der Paste auf den transparenten leitenden Film (2, 18) in einem Zustand durchgeführt wird, in dem ein elektrostatisches Feld zwischen dem transparenten leitenden Film (2, 18) und der Elektrode, die diesem gegenüberliegt, erzeugt wird.

## Revendications

1. Elément de conversion photoélectrique formé de telle manière qu'une électrode de référence servant comme une électrode négative et une contre-électrode (11) servant comme une électrode positive sont arrangées pour s'opposer l'une à l'autre, où:
- l'électrode de référence, est construite en formant un film photocatalyseur (8) coloré avec un colorant photosensibilisant par un film conducteur transparent (2, 18) sur une surface d'un substrat transparent (1) et
- la contre-électrode (11) est construite en disposant, sur une surface d'un substrat pour la contre-électrode (4), un nanotube de carbone en forme de brosse orienté substantiellement perpendiculaire à la surface du substrat en transcrivant un nanotube de carbone en forme de brosse formé séparément par une couche à agent adhésif conducteur (7) qui couvre la surface.

2. Elément de conversion photoélectrique selon la revendication 1, où l'électrode de référence est construite en permettant à un nanotube de carbone en forme de brosse disposé substantiellement perpendiculaire à la surface du substrat sur le film conducteur transparent (2, 18) sur le substrat transparent (1) pour transporter les particules de photocatalyseur, et en colorant les particules avec un colorant photosensibilisant.

3. Elément de conversion photoélectrique selon la revendication 1, où l'électrode de référence est construite en formant un film photocatalyseur (8) fait d'une mixture de particules de nanotube de carbone (25) et de particules de photocatalyseur sur le film conducteur transparent (2, 18), sur le substrat transparent (1), et en colorant le film catalyseur (8) avec un colorant photosensibilisant.

4. Elément de conversion photoélectrique selon la revendication 3, où l'électrode de référence est en contact avec le nanotube de carbone en forme de brosse de la contre-électrode (11).

5. Procédé de fabrication un élément de conversion photoélectrique formé de telle manière qu'une électrode de référence servant comme une électrode négative et une contre-électrode (11) servant comme une électrode positive sont arrangées pour s'opposer l'une à l'autre, où:
- l'électrode de référence, est construite en formant un film photocatalyseur (8) coloré avec un colorant photosensibilisant par un film conducteur transparent (2, 18) sur une surface d'un substrat transparent (1), et
- la contre-électrode (11) est construite en formant, sur une surface d'un substrat pour la contre- électrode (4), une couche à agent adhésif conducteur (7) pour couvrir la surface, et en transcrivant un nanotube de carbone en forme de brosse formé séparément sur la couche à agent adhésif (7) de telle manière que le nanotube de carbone en forme de brosse puisse être orienté substantiellement perpendiculaire à la surface du substrat.

6. Procédé de fabrication un élément de conversion photoélectrique selon la revendication 5, où l'électrode de référence est construite en formant un film conducteur transparent (2, 18) sur une surface d'un substrat transparent (1), en transcrivant un nanotube de carbone en forme de brosse formé séparément sur le film conducteur de telle manière que le nanotube de carbone en forme de brosse puisse être orienté substantiellement perpendiculaire à la surface du substrat, en permettant au nanotube de carbone transporter les particules de photocatalisateur, en en colorant les particules avec un colorant photosensibilisant.

7. Procédé de fabrication un élément de conversion photoélectrique selon la revendication 5, où l'électrode de référence est construite en formant un film conducteur transparent (2, 18) sur une surface d'un substrat transparent (1), en formant un film photocatalyseur (8) fait d'une mixture de particules de nanotube de carbone (25) et de particules de photocatalyseur sur le film conducteur, et en colorant le film catalyseur avec un colorant photosensibilisant.

8. Procédé de fabrication un élément de conversion photoélectrique selon la revendication 7, où, en formant un film photocatalyseur (8) fait d'une mixture de particules de nanotube de carbone (25) et de particules de photocatalyseur sur le film conducteur transparent (2, 18), une pâte contenant la mixture est appliquée sur le film conducteur transparent (2, 18), suivie par séchage.

9. Procédé de fabrication un élément de conversion phôtoélectrique selon la revendication 8, où, dans l'application de la pâte sur le film conducteur transparent (2, 18), l'application est réalisée dans un état dans lequel un champs électrostatique est formé entre le film conducteur transparent (2, 18) et l'électrode s'opposant à celui-ci.
